# EUROPEAN PATENT APPLICATION

(11) **EP 3 923 324 A1**
(43) Date of publication of application: **15.12.2021**
(21) Application number: 20208021.4
(22) Date of filing: 17.11.2020
(51) Int. Cl.: H01L 25/065, H01L 23/00, H01L 25/16, H01L 25/18

(54) **HIGH SPEED MEMORY SYSTEM INTEGRATION**

(30) Priority: 10.06.2020 US 202016898198
(71) Applicant: INTEL Corporation, Santa Clara, CA 95054 (US)
(72) Inventor: Tomishima, Shigeki, Portland, 97229 (US); MALLIK, Debendra, Chandler, AZ Arizona 85226 (US); Koker, Allug, El Dorado Hills, OR Oregon 95762 (US)
(74) Representative: Goddar, Heinz J.

(57) **Abstract**

Embodiments disclosed herein include multi-die electronic packages. In an embodiment, an electronic package comprises a package substrate and a first die electrically coupled to the package substrate. In an embodiment, an array of die stacks are electrically coupled to the first die. In an embodiment the array of die stacks are between the first die and the package substrate. In an embodiment, individual ones of the die stacks comprise a plurality of second dies arranged in a vertical stack.

## Description

### TECHNICAL FIELD

Embodiments of the present disclosure relate to semiconductor devices, and more particularly to electronic packages with a compute die over an array of memory die stacks.

### BACKGROUND

The drive towards increased computing performance has yielded many different packaging solutions. In one such packaging solution, dies are arranged over a base substrate. The dies may include compute dies and memory dies. Connections between the compute dies and the memory dies are provided in the base substrate. While higher density is provided, the lateral connections over the base substrate result in higher power consumption and reduced bandwidth. Such integration may not be sufficient to meet the memory capacity and bandwidth needs of certain applications, such as high performance computing (HPC) applications.

### BRIEF DESCRIPTION OF THE DRAWINGS

Figure 1A is a plan view illustration of an electronic package with a plurality of compute dies and memory dies over a base substrate.
Figure 1B is a cross-sectional illustration of the electronic package in Figure 1A.
Figure 2 is a perspective view illustration of an electronic package that comprises a first die and an array of die stacks below the first die, in accordance with an embodiment.
Figure 3A is a cross-sectional illustration of an electronic package with a first die and an array of die stacks attached to a package substrate, in accordance with an embodiment.
Figure 3B is a cross-sectional illustration of an electronic package with a first die and an array of die stacks attached to a base substrate, in accordance with an embodiment.
Figure 3C is a cross-sectional illustration of an electronic package with a first die over a base substrate and an array of die stacks below the base substrate, in accordance with an embodiment.
Figure 3D is a cross-sectional illustration of an electronic package with a first die over an array of die stacks with a base substrate over the first die, in accordance with an embodiment.
Figure 3E is a cross-sectional illustration of an electronic package with a first die over an array of die stacks with the first die directly connected to a package substrate, in accordance with an embodiment.
Figure 3F is a cross-sectional illustration of an electronic package with a first die over an array of die stacks with the first die directly connected to a base substrate, in accordance with an embodiment.
Figure 3G is a cross-sectional illustration of an electronic package with a plurality of first dies over an array of die stacks with a direct electrical connection from the first dies to a base substrate, in accordance with an embodiment.
Figure 3H is a cross-sectional illustration of an electronic package with a plurality of first dies over an array of die stacks with a direct electrical connection from the first dies to a package substrate, in accordance with an embodiment.
Figure 3I is a cross-sectional illustration of an electronic package with a plurality of first dies over an array of die stacks with a power delivery path from a base substrate to the first dies that passes through the die stacks, in accordance with an embodiment.
Figure 4A is a plan view illustration of a first die with power delivery pads in a grid and I/O pads within each compute engine cluster, in accordance with an embodiment.
Figure 4B is a plan view illustration of a memory die that may be used in conjunction with the first die in Figure 4A, in accordance with an embodiment.
Figure 5A is a plan view illustration of a first die with power delivery pads and I/O pads within each compute engine cluster, in accordance with an embodiment.
Figure 5B is a plan view illustration of a memory die that may be used in conjunction with the first die in Figure 5A, in accordance with an embodiment.
Figure 6 is a cross-sectional illustration of an electronic system with an electronic package that comprises a first die over an array of die stacks, in accordance with an embodiment.
Figure 7 is a schematic of a computing device built in accordance with an embodiment.

### EMBODIMENTS OF THE PRESENT DISCLOSURE

Described herein are electronic packages with a compute die over an array of memory die stacks, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

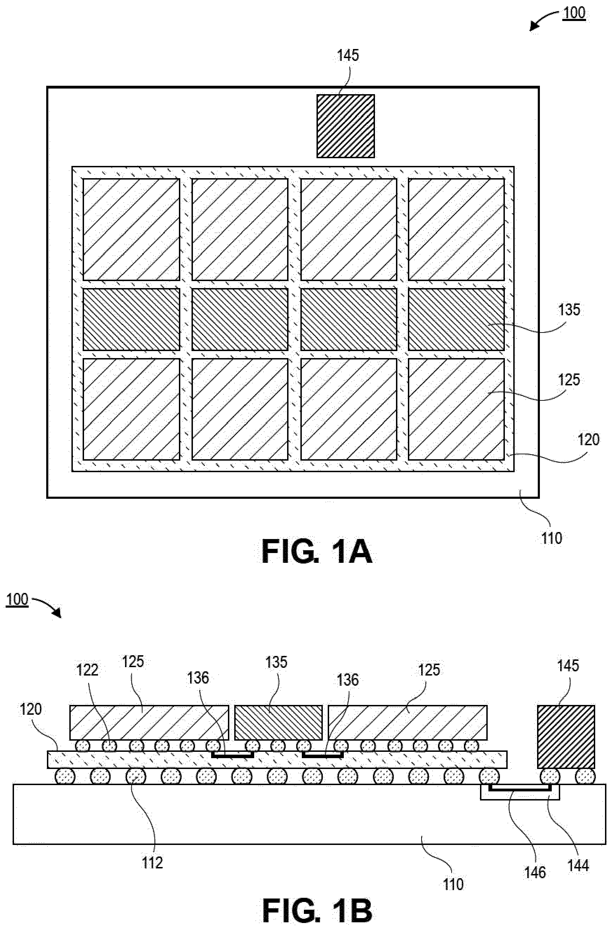

As noted above, existing electronic packaging architectures may not provide the memory capacity and bandwidth sufficient for some high performance computing (HPC) systems. An example of one such existing electronic package 100 is shown in Figures 1A and 1B. As shown, the electronic package 100 comprises a package substrate 110 with a base substrate 120 over the package substrate 110. The base substrate 120 may be an active substrate. For example, the base substrate 120 may comprise circuitry for memory (e.g., SRAM), I/O, and power management (e.g., a fully integrated voltage regulator (FIVR)). Integration of such circuitry components into the base substrate 120 requires a relatively advanced process node (e.g., 10nm or smaller or larger). This is further complicated by the requirement that the area of the base substrate 120 be relatively larger (e.g., hundreds of mm2). As such, the yield of such base substrates 120 is low, which drives up the cost of the base substrate 120. The base substrate 120 may be attached to the package substrate 110 by interconnects 112.

As shown, a plurality of first dies 125 and second dies 135 may be disposed in an array over the base substrate 120. The first dies 125 may be compute dies (e.g., CPU, GPU, etc.), and the second dies 135 may be memory dies. The first dies 125 and the second dies 135 may be attached to the base substrate 120 by interconnects 122. It is to be appreciated that the number of second dies 135 is limited by the footprint of the base substrate 120. Since it is difficult to form large area base substrates 120, the number second dies 135 is limited. As such, the memory capacity of the electronic package 100 is limited. In order to provide additional memory, a high bandwidth memory (HBM) 145 stack may be attached to the package substrate 110. The HBM 145 may be electrically coupled to the base substrate 120 by an embedded bridge 144 or other conductive routing architecture.

The first dies 125 may be electrically coupled to the second dies 135 through interconnects 136 (e.g., traces, vias, etc.) in the base substrate 120. Similarly, an interconnect 146 through the bridge 144 may electrically couple the HBM 145 to the base substrate 120. Such lateral routing increases power consumption and decreases the available bandwidth of the memory.

Accordingly, embodiments disclosed herein include an electronic packaging architecture that allows for improved memory capacity and bandwidth. Particularly, embodiments disclosed herein include a first die (e.g., a compute die) and an array of die stacks comprising second dies (e.g., memory dies) that are coupled to the first die. The three-dimensional (3D) stacking of the second dies allows for increased memory capacity within a restricted footprint. Additionally, each die stack may be located below a compute engine cluster of the first die. In some embodiments, local compute engines within a cluster may be above a memory block of individual ones of the second dies. Therefore, each compute engine cluster has direct access to memory with minimal lateral routing. This reduces the power consumption and provides an increase to bandwidth. In some embodiments, power delivery paths from the package substrate (or the base substrate) to the first die may be routed between the die stacks. In other embodiments, the power delivery paths may be routed through the die stacks.

The additional memory capacity also allows for offloading memory from the base substrate. Without the need to provide memory in the base substrate, the processing node of the base substrate may be relaxed. For example, the base substrate may be processed at the 14nm or 22nm process node. As such, yields of the base substrate are improved and costs are decreased. Additionally, larger area base substrates may be provided, which allows for even more memory capacity to be provided.

In an embodiment, a plurality of first dies may be included in the electronic package. For example, each first die may be positioned over a different portion of the array of die stacks. Each first die, may therefore have a dedicated bank of memory. This allows for smaller compute dies, and therefore may drive a higher yield and lower costs. The use of die stacks may also improve yield of the electronic package. For example, each die stack may be tested prior to assembly. As such, only known good die stacks may be included in the electronic package.

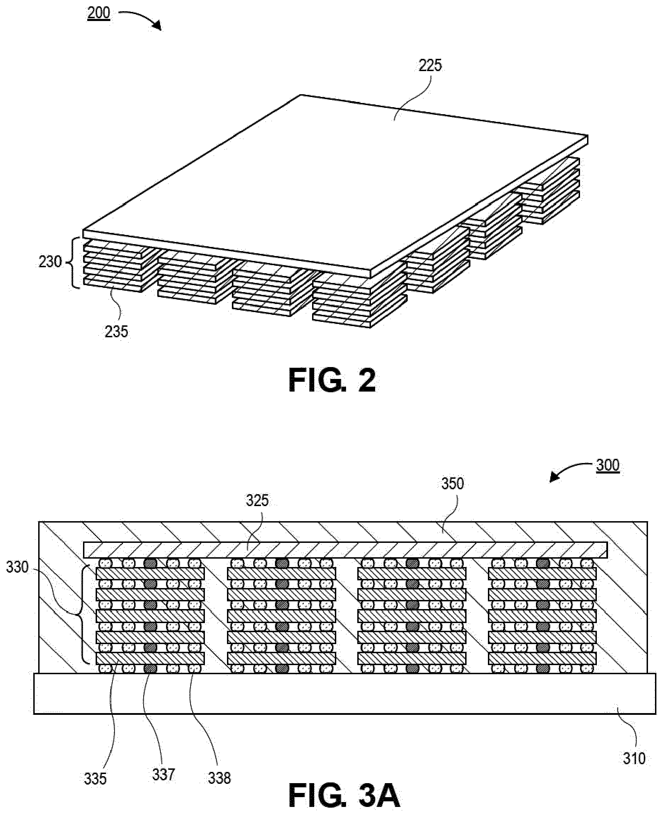

Referring now to Figure 2 a perspective view illustration of an electronic package 200 is shown, in accordance with an embodiment. In Figure 2, only the first die 225 and an array of die stacks 230 are shown for simplicity. It is to be appreciated that other components (as will be described in greater detail below) may be included in the electronic package 200. In an embodiment, the first die 225 may be a compute die. For example, the first die 225 may comprise a processor (e.g., CPU), a graphics processor (e.g. GPU), application processors (e.g., TPU, FPGA, etc.), or any other type of die that provides computation capabilities. In an embodiment, the die stacks 230 may comprise a plurality of second dies 235 arranged in a vertical stack. The second dies 235 may be memory dies. In a particular embodiment, the memory dies are SRAM memory, though other types of memory (e.g., eDRAM, STT-MRAM, ReRAM, 3DXP, etc.) may also be included in the die stacks 230. Additionally, the second dies 235 may comprise multiple different types of memories.

In the illustrated embodiment, the array of die stacks 230 comprises a four-by-four array. That is, there are 16 instances of the die stacks 230 shown in Figure 2. However, it is to be appreciated that the array may comprise any number of die stacks 230. Furthermore, while a square array is shown, it is to be appreciated that the array may be any shape. For example, the array of die stacks 230 may be a four-by-two array. In the illustrated embodiment, each die stack 230 comprises four second dies 235. However, it is to be appreciated that embodiments may include any number of second dies 235 in the die stack 230. For example, one or more second dies 235 may be included in each die stack 230.

Referring now to Figure 3A, a cross-sectional illustration of an electronic package 300 is shown, in accordance with an embodiment. The electronic package 300 may comprise a package substrate 310, an array of die stacks 330, and a first die 325. A mold layer 350 may be disposed over the array of die stacks 330 and the first die 325.

In an embodiment, the package substrate 310 may be any suitable packaging substrate. For example, the package substrate 310 may be cored or coreless. In an embodiment, the package substrate 310 may comprise conductive features (not shown for simplicity) to provide routing. For example, conductive traces, vias pads, etc. may be included in the package substrate.

In an embodiment, each die stack 330 may comprise a plurality of second dies 335. In the illustrated embodiment five second dies 335 are shown in each die stack 330, but it is to be appreciated that the die stacks 330 may comprise two or more second dies 335. In an embodiment, the second dies 335 may be connected to each other by interconnects 337/338. Interconnects 338 represent power supply interconnects, and interconnects 337 may represent communication interconnects (e.g., I/O, CA, etc.). In an embodiment, through substrate vias (TSVs) may pass through the second dies 335. The TSVs are not shown for simplicity. In a particular embodiment, the interconnects 337/338 are implemented using a TSV/micro-bump architecture. In other embodiments, hybrid wafer bonding may be used to interconnect the stacked second dies. However, it is to be appreciated that other suitable interconnect architectures may also be used. As shown, the power delivery path from the package substrate 310 to the first die 325 is provided through the die stacks 330. That is, power supply interconnects 338 are shown coupling the topmost second dies 335 to the first die 325.

In an embodiment, the first die 325 may be a compute die. For example, the first die 325 may comprise a processor (e.g., CPU), a graphics processor (e.g. GPU), or any other type of die that provides computation capabilities. The second dies 335 may be memory dies. In a particular embodiment, the memory dies are SRAM memory, though other types of memory (e.g., e.g., eDRAM, STT-MRAM, ReRAM, 3DXP, etc.) may also be included in the die stacks 330. In an embodiment, the first die 325 may be fabricated at a different process node than the second dies 335. For example, the first die 325 may be fabricated at with a more advanced process node than the second dies 335.

In an embodiment, the die stacks 330 that are integrated into the electronic package 330 may be known good die stacks 330. That is, the individual die stacks 330 may be tested prior to assembly. As such, embodiments may include providing only functional die stacks 330 in the assembly of the electronic package 330. This provides an increase in the yield of the electronic package 300 and reduces costs.

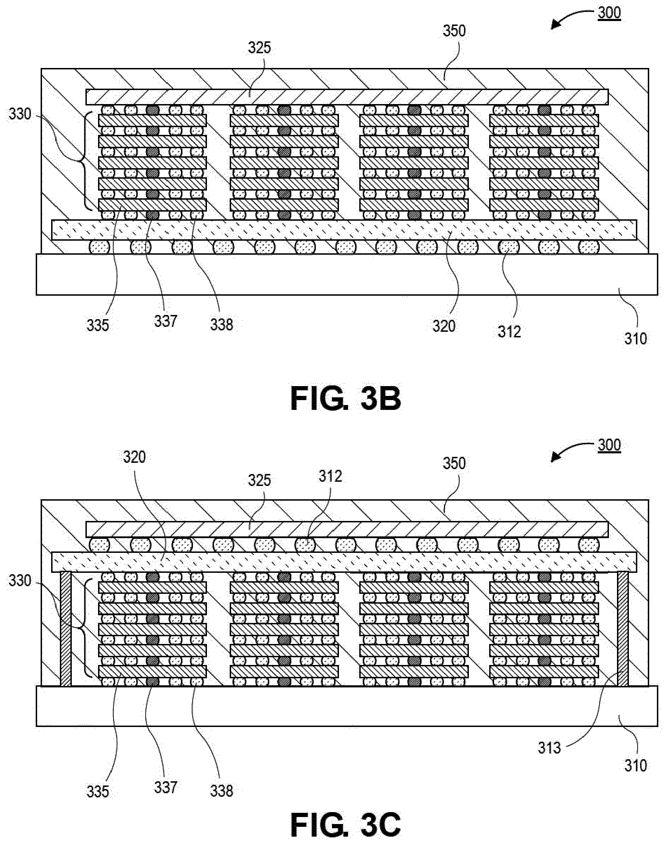

Referring now to Figure 3B, a cross-sectional illustration of an electronic package 300 is shown, in accordance with an additional embodiment. The electronic package 300 in Figure 3B may be substantially similar to the electronic package 300 in Figure 3A, with the exception that a base substrate 320 is provided between the array of die stacks 330 and the package substrate 310. In an embodiment, the base substrate 320 may be attached to the package substrate 310 by interconnects 312, such as solder bumps or the like.

In an embodiment, the base substrate 320 may be a semiconductor material. For example, the base substrate 320 may comprise silicon or the like. In an embodiment, the base substrate 320 may be a passive substrate, without any active circuitry. In other embodiments, the base substrate 320 may be an active substrate that comprises active circuitry. In an embodiment, the base substrate 320 may comprise power regulation circuitry blocks (e.g., FIVR, or the like). Furthermore, in some embodiments, the base substrate 320 may be substantially free of memory circuitry (e.g., SRAM blocks). This is because the die stacks 330 provide sufficient memory capacity for the electronic package 300.

In some embodiments, the base substrate 320 may be fabricated at a process node that is different than the process nodes of the first die 325 and the second dies 335 in the die stacks 330. For example, the first die 325 may be fabricated at a 7nm process node, the second dies 335 may be fabricated at a 10nm process node, and the base substrate 320 may be fabricated at a 14nm process node or larger. As such, the cost of the base substrate 320 is reduced. Additionally, the footprint of the base substrate 320 may be increased in order to provide more area for die stacks 330. In an embodiment, the footprint of the base substrate 320 may be larger than the footprint of the array of die stacks 330 and larger than the footprint of the first die 325. In an embodiment, the footprint of the base substrate 320 may be approximately 100mm2 or larger, approximately 200mm2 or larger, or approximately 500mm2 or larger.

Referring now to Figure 3C, a cross-sectional illustration of an electronic package 300 is shown, in accordance with an additional embodiment. The electronic package 300 in Figure 3C is substantially similar to the electronic package 300 in Figure 3B, with the exception of the location of the base substrate 320. As shown, the base substrate 320 may be positioned between the die stacks 330 and the first die 325. In some embodiments, a direct electrical connection 313 may be provided from the base substrate 320 to the package substrate 310. That is, an electrical connection 313 from the base substrate 320 to the package substrate 310 may pass adjacent to the die stacks 330. However, it is to be appreciated that embodiments may also include an electrical connection from the base substrate 320 to the package substrate 310 that passes through die stacks 330.

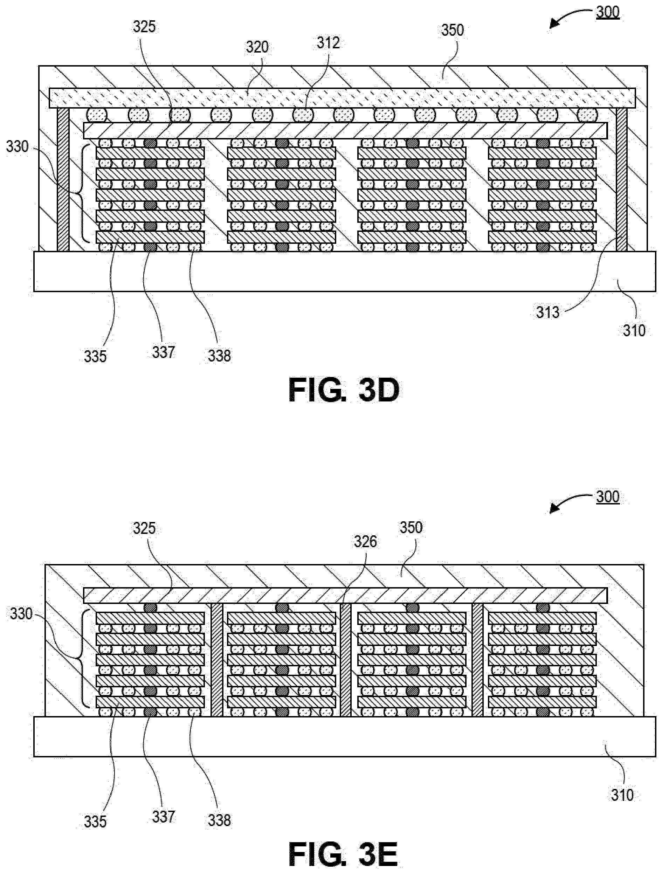

Referring now to Figure 3D, a cross-sectional illustration of an electronic package 300 is shown, in accordance with an additional embodiment. In an embodiment, the electronic package 300 in Figure 3D is substantially similar to the electronic package 300 in Figure 3B, with the exception of the location of the base substrate 320. As shown, the base substrate 320 may be positioned above the first die 325. In some embodiments, a direct electrical connection 313 may be provided from the base substrate 320 to the package substrate 310. That is, an electrical connection 313 from the base substrate 320 to the package substrate 310 may pass adjacent to the die stacks 330 and the first die 325. However, it is to be appreciated that embodiments may also include an electrical connection from the base substrate 320 to the package substrate 310 that passes through die stacks 330.

Referring now to Figure 3E, a cross-sectional illustration of an electronic package 300 is shown, in accordance with an additional embodiment. In an embodiment, the electronic package 300 in Figure 3E may be substantially similar to the electronic package 300 in Figure 3A, with the exception that a power delivery path 326 from the package substrate 310 to the first die 325 may pass outside of the die stacks 330. As shown, power delivery paths 326 are positioned between the die stacks 330. In an embodiment, the power delivery paths 326 may comprise through mold vias (TMVs), copper pillars, or any other suitable interconnect architecture for providing a vertical connection through the mold layer 350.

Since the power delivery path to the first die 325 is not provided through the die stacks 330, the topmost second dies 335 may only include communication interconnects 337. However, in other embodiments, dummy power interconnects (i.e., interconnects that provide structural support but are not active parts of the circuitry) may be provided over the topmost second dies 335 to provide manufacturing and mechanical reliability. It is to be appreciated that the power delivery paths through the die stacks 330 may be made with interconnects 338.

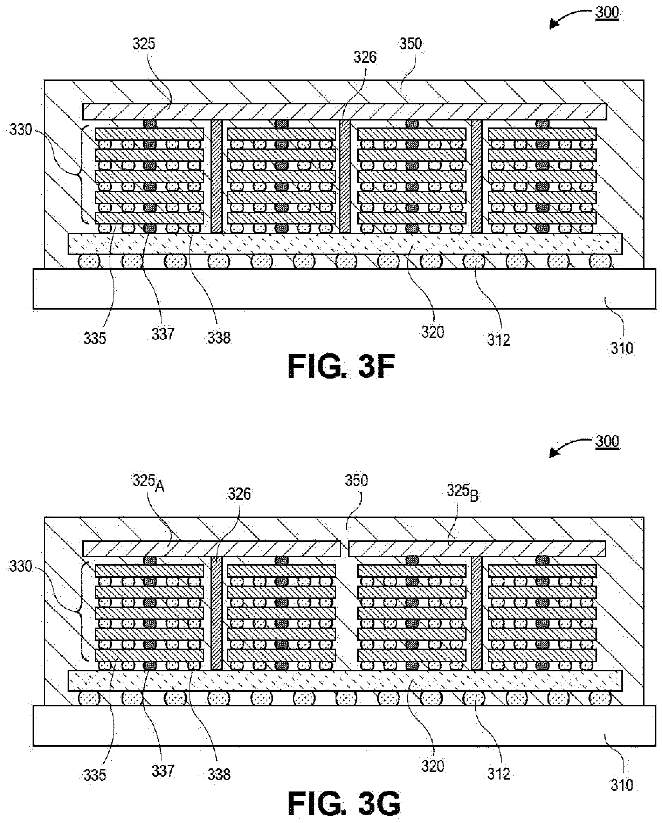

Referring now to Figure 3F, a cross-sectional illustration of an electronic package 300 is shown, in accordance with an additional embodiment. In an embodiment, the electronic package in Figure 3F is substantially similar to the electronic package 300 in Figure 3E, with the exception that a base substrate 320 is provided between the die stacks 330 and the package substrate 320. In an embodiment, the base substrate 320 may be attached to the package substrate 310 by interconnects 312, such as solder bumps or the like. In an embodiment, the power delivery paths 326 may provide direct electrical coupling between the first die 325 and the base substrate 320.

Referring now to Figure 3G, a cross-sectional illustration of an electronic package 300 is shown, in accordance with an additional embodiment. In an embodiment, the electronic package 300 in Figure 3G is substantially similar to the electronic package 300 in Figure 3F, with the exception that a plurality of first dies 325 are provided over the array of die stacks 330. For example, first die 325_{A} and first die 325_{B} are illustrated. However, it is to be appreciated that any number of first dies 325 may be included in the electronic package 300. In some embodiments, the first dies 325_{A} and 325_{B} may be substantially similar to each other. In other embodiments, the first dies 325_{A} and 325_{B} may have different functionalities. Furthermore, while shown as being substantially the same dimensions in Figure 3G, it is to be appreciated that the first dies 325_{A} and 325_{B} do not need to have the same dimensions. In the illustrated embodiment, the first dies 325_{A} and 325_{B} are over different die stacks 330. In other embodiments, a single die stack 330 may be below two or more different first dies 325.

In an embodiment, each of the first dies 325_{A} and 325_{B} may be directly connected to an underlying base substrate 320. For example, power delivery paths 326 pass through the mold layer 350 outside of the die stacks 330 between the first dies 325 and the base substrate 320. The power delivery paths 326 may be TMVs, pillars, or any other conductive structure to provide a vertical connection through the mold layer 350. Since the power delivery path 326 is not provided through the die stacks 330, the topmost second dies 335 may only include communication interconnects 337. However, in other embodiments, dummy power interconnects (i.e., interconnects that provide structural support but are not active parts of the circuitry) may be provided over the topmost second dies 335 to provide manufacturing and mechanical reliability.

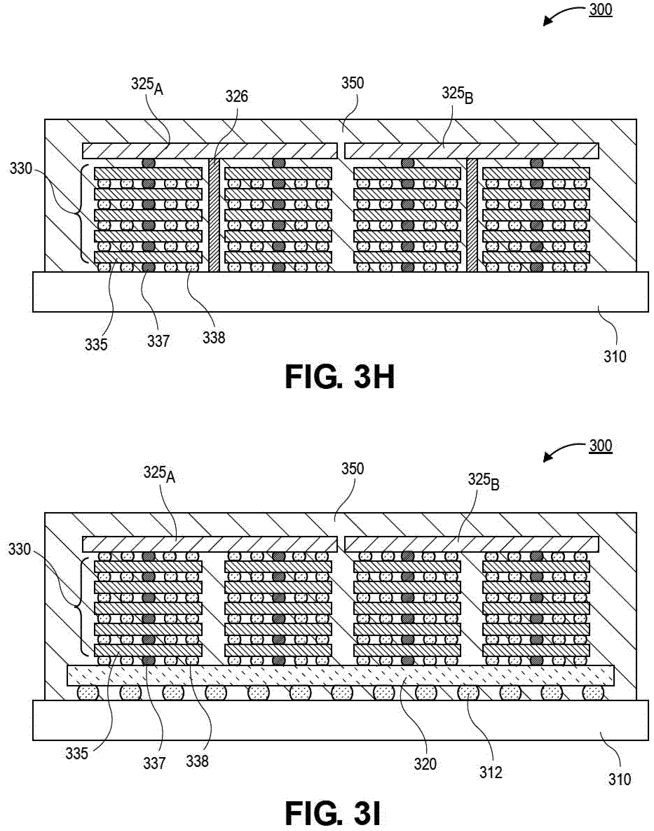

Referring now to Figure 3H, a cross-sectional illustration of an electronic package 300 is shown, in accordance with an additional embodiment. The electronic package 300 in Figure 3H may be substantially similar to the electronic package 300 in Figure 3G, with the exception that the base substrate 320 is omitted. In such embodiments, the die stacks 330 may be attached directly to the package substrate 310. Additionally, the power delivery paths 326 may provide a direct electrical connection from the first dies 325_{A}/325_{B} to the package substrate 310.

Referring now to Figure 3I, a cross-sectional illustration of an electronic package 300 is shown, in accordance with an additional embodiment. The electronic package 300 in Figure 3I may be substantially similar to the electronic package 300 in Figure 3G, with the exception that the power delivery paths 326 outside of the die stacks 330 are omitted. Instead, power delivery to the first dies 325_{A}/325_{B} may be provided through the die stacks 330. For example, the topmost second dies 335 may be connected to the first dies 325_{A}/325_{B} by communication interconnects 337 and power supply interconnects 338.

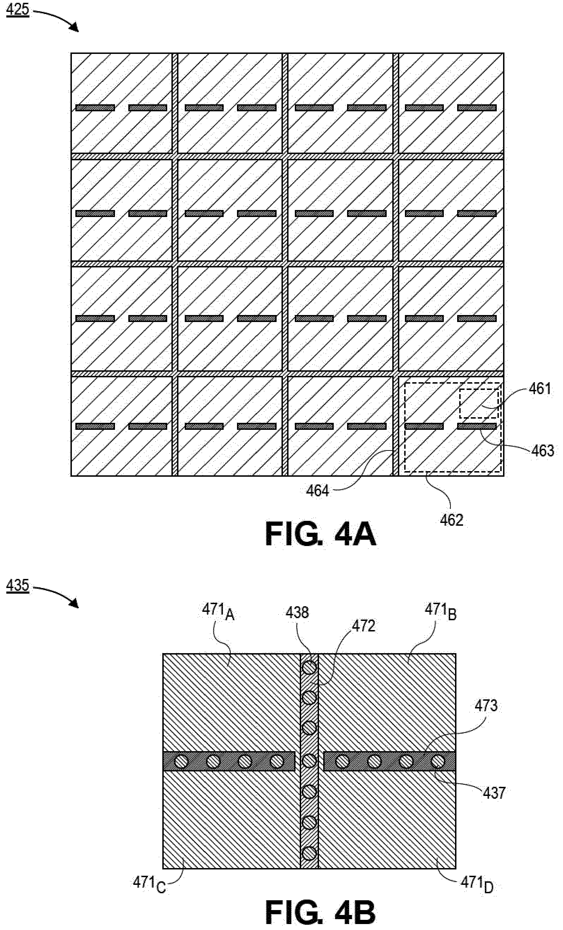

Referring now to Figure 4A, a plan view illustration of a surface of a first die 425 is shown, in accordance with an embodiment. In an embodiment, the first die 425 may comprise a plurality of compute engine clusters 462. A plurality of local compute engines 461 may be provided within each of the clusters 462. In order to minimize routing, the memory resources that are dedicated to each cluster 462 is provided below the cluster 462. As such, each cluster 462 may be located above one of the die stacks. For example, the first die 425 comprises sixteen clusters 462, and each of the clusters 462 may be positioned over one of the die stacks. Accordingly, embodiments disclosed herein require minimal (if any at all) lateral routing in order for the first die 425 to access the memory resources in the electronic package.

Lateral routing may be further reduced by locating individual memory blocks in a memory die below a local compute engine 461. For example, Figure 4B is a plan view illustration of a second die 435 (e.g., a memory die) that may be provided in a die stack below the first die 425. In an embodiment, the second die 435 may comprise a plurality of blocks 471_{A-D}. Each of the blocks 471_{A-D} may be located below an individual one of the local compute engines 461. For example, each second die 435 may comprise four blocks 471, and the overlying cluster 462 may comprise four local compute engines 461, with an individual one of the local compute engines 461 over an individual one of the blocks 471.

Figure 4B also illustrates pads 472/473 and interconnects 437/438. Power delivery interconnects 438 may be provided on pads 472, and communication interconnects 437 may be provided on pads 473. In the instance of a topmost second die 435 in a die stack, the power delivery interconnects 438 may be omitted, or dummy power delivery interconnects 438 may be provided. This is because, the power delivery pads 464 on the first die 425 are outside of the footprint of the die stacks. As such, power delivery paths similar to the power delivery paths 326 shown in Figures 3E and 3F may be used to provide power to the first die 425.

In an embodiment, communication pads 463 may be provided within each cluster 462 of the first die 425. The communication pads 463 are positioned to interface with the communication interconnects 437 of the second dies 437. While a simple linear layout of the communication interconnects 437 is shown, it is to be appreciated that the communication interconnects 437 may have any suitable layout.

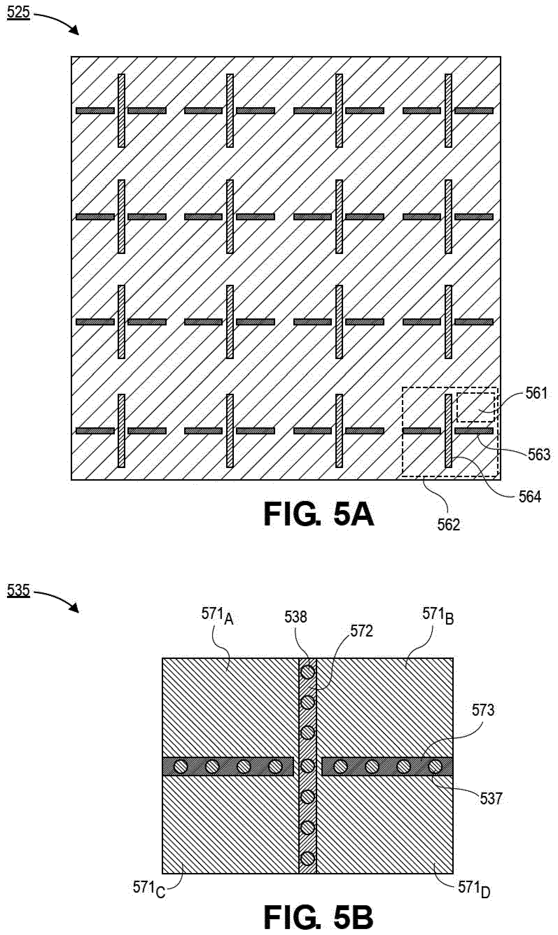

Referring now to Figures 5A and 5B, plan view illustrations of a surface of a first die 525 and a surface of a second die 535 are shown, respectively, in accordance with an embodiment. The second die 535 may be substantially similar to the second die 435 in Figure 4B. That is, the second die 535 may comprise a plurality of blocks 571_{A-D}, with power delivery interconnects 538 provided on pads 572 and communication interconnects 537 on pads 573.

In an embodiment, the first die 525 in Figure 5A is similar to the first die 425 in Figure 4A, with the exception that the power delivery pads 564 are within the compute engine clusters 562. That is, the first die 525 is set up to receive power through the die stacks, similar to the embodiments shown in Figures 3A and 3B. Since the power is deliver through the die stacks, the power delivery interconnects 538 on the topmost second dies 535 are active in order to provide power to the power delivery pads 564 within each of the clusters 563.

Similar to the embodiment described with respect to Figures 4A and 4B, the clusters 563 may each comprise a plurality of local compute engines 561. Each of the local compute engines 561 may be positioned over one of the blocks 571 in the underlying second die 535. Additionally, the pads 572/573 of the second die 535 may be aligned with the pads 564/563 of the first die 525. While a cross pattern is shown, it is to be appreciated that the pads 572/573 and 564/563 may have any suitable layout.

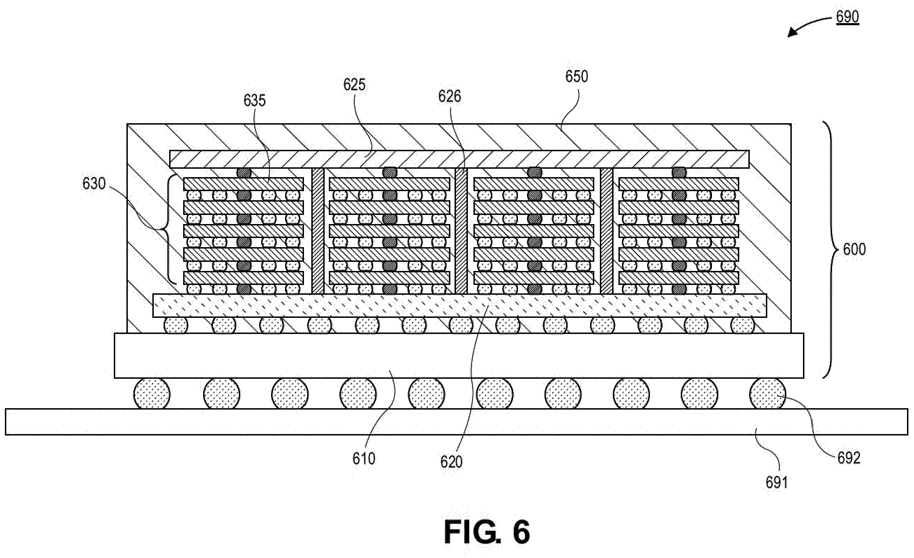

Referring now to Figure 6, a cross-sectional illustration of an electronic system 690 is shown, in accordance with an embodiment. In an embodiment, the electronic system 690 may comprise an electronic package 600 that is attached to a board 691. The electronic package 600 may be attached to the board 691 by interconnects 692. In the illustrated embodiment, the interconnects 692 are shown as being solder balls. However, it is to be appreciated that the interconnects 692 may be any suitable interconnects, such as sockets, wire bonds, or the like.

In an embodiment, the electronic package 600 may comprise a package substrate 610. A base substrate 620 may be disposed over the package substrate 610. In an embodiment, an array of die stacks 630 may be positioned over the base substrate 620. The die stacks 630 may each comprise a plurality of second dies 635. For example, the second dies 635 may be memory dies. A first die 625 may be disposed over the die stacks 630. The first die 625 may be a compute die. In an embodiment, the first die 625 may be provided power through a power delivery paths 626 that directly connects to the base substrate 620. In an embodiment, a mold layer 650 may surround the electronic package 600.

In Figure 6, an electronic package 600 is similar to the electronic package 300 in Figure 3F is shown. However, it is to be appreciated that the electronic package 600 in the electronic system 690 may be similar to electronic packages in accordance with any embodiments disclosed herein. For example, electronic package 600 may be similar to any of the electronic packages 300 in Figures 3A-5B.

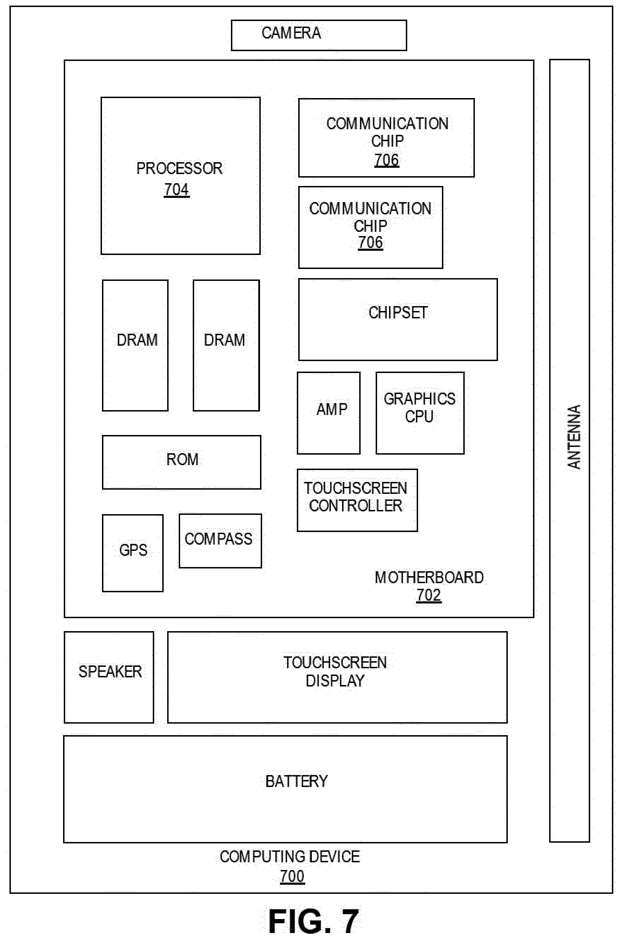

Figure 7 illustrates a computing device 700 in accordance with one implementation of the invention. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the invention, the integrated circuit die of the processor may be part of an electronic package that comprises a first die over an array of die stacks, in accordance with embodiments described herein. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of the invention, the integrated circuit die of the communication chip may be part of an electronic package that comprises a first die over an array of die stacks, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.
Example 1: an electronic package, comprising: a package substrate; a first die electrically coupled to the package substrate; and an array of die stacks electrically coupled to the first die, wherein the array of die stacks are between the first die and the package substrate, and wherein individual ones of the die stacks comprise: a plurality of second dies arranged in a vertical stack.
Example 2: the electronic package of Example 1, wherein the first die is a compute die, and wherein the second dies are memory dies.
Example 3: the electronic package of Example 1 or Example 2, further comprising: a base substrate.
Example 4: the electronic package of Example 3, wherein the base substrate is between the array of die stacks and the package substrate.
Example 5: the electronic package of Example 3, wherein the base substrate is between the array of die stacks and the first die.
Example 6: the electronic package of Example 3, wherein the first die is between the base substrate and the package substrate.
Example 7: the electronic package of Examples 3-6, wherein the base die is a passive substrate.
Example 8: the electronic package of Examples 3-6, wherein the base die is an active substrate.
Example 9: the electronic package of Example 8, wherein the base die comprises circuitry for power delivery.
Example 10: the electronic package of Examples 1-9, wherein a power delivery path from the package substrate to the first die passes through one or more of the second dies.
Example 11: the electronic package of Examples 1-10, wherein a power delivery path from the package substrate to the first die passes between die stacks.
Example 12: the electronic package of Examples 1-11, further comprising: a third die, wherein a first portion of the array of die stacks is below the first die, and wherein a second portion of the array of die stacks is below the third die.
Example 13: an electronic package, comprising: a package substrate; a base substrate over the package substrate; an array of die stacks over the base substrate; and a first die over the array of die stacks.
Example 14: the electronic package of Example 13, wherein the first die comprises a plurality of compute engine clusters, and wherein an individual one of the die stacks is positioned below an individual one of the compute engine clusters.
Example 15: the electronic package of Example 14, wherein individual die stacks comprise a plurality of second dies, and wherein each second die comprises a plurality of memory blocks.
Example 16: the electronic package of Example 15, wherein each compute engine cluster comprises a plurality of local compute engines, and wherein individual ones of the local compute engines are above individual ones of the memory blocks.
Example 17: the electronic package of Examples 13-16, wherein a power delivery path from the package substrate to the first die passes through the plurality of die stacks.
Example 18: the electronic package of Examples 13-17, wherein a power delivery path from the package substrate to the first die passes between die stacks.
Example 19: the electronic package of Examples 13-18, further comprising: a third die, wherein a first portion of the array of die stacks is below the first die, and wherein a second portion of the array of die stacks is below the third die.
Example 20: the electronic package of Examples 13-19, wherein the array of die stacks comprises a four by four array of die stacks.
Example 21: the electronic package of Examples 13-20, wherein individual die stacks comprise two or more second dies arranged in a vertical stack.
Example 22: the electronic package of Example 21, wherein the first die is a compute die, and wherein the second dies are memory dies.
Example 23: an electronic system, comprising: a board; a package substrate attached to the board; a first die electrically coupled to the package substrate; and an array of die stacks electrically coupled to the first die, wherein individual ones of the die stacks comprise: a plurality of second dies arranged in a vertical stack.
Example 24: the electronic system of Example 23, further comprising: a base substrate, wherein the base substrate is between the package substrate and the array of die stacks, between the array of die stacks and the first die, or over the first die.
Example 25: the electronic system of Example 23 or Example 24, wherein a power delivery path from the package substrate to the first die passes between die stacks or passes through the die stacks.

## Claims

1. An electronic package, comprising:
a package substrate;
a first die electrically coupled to the package substrate; and
an array of die stacks electrically coupled to the first die, wherein the array of die stacks are between the first die and the package substrate, and wherein individual ones of the die stacks comprise:
a plurality of second dies arranged in a vertical stack.

2. The electronic package of claim 1, wherein the first die is a compute die, and
wherein the second dies are memory dies.

3. The electronic package of claim 1 or 2, further comprising:
a base substrate.

4. The electronic package of claim 3, wherein the base substrate is between the array of die stacks and the package substrate.

5. The electronic package of claim 3, wherein the base substrate is between the array of die stacks and the first die.

6. The electronic package of claim 3, wherein the first die is between the base substrate and the package substrate.

7. The electronic package of claim 3, 4, 5 or 6, wherein the base die is a passive substrate.

8. The electronic package of claim 3, 4, 5 or 6, wherein the base die is an active substrate.

9. The electronic package of claim 8, wherein the base die comprises circuitry for power delivery.

10. The electronic package of claim 1, 2, 3, 4, 5, 6, 7, 8 or 9, wherein a power delivery path from the package substrate to the first die passes through one or more of the second dies.

11. The electronic package of claim 1, 2, 3, 4, 5, 6, 7, 8, 9 or 10, wherein a power delivery path from the package substrate to the first die passes between die stacks.

12. The electronic package of claim 1, 2, 3, 4, 5, 6, 7, 8, 9, 10 or 11, further comprising:
a third die, wherein a first portion of the array of die stacks is below the first die, and wherein a second portion of the array of die stacks is below the third die.

13. A method of fabricating an electronic package, the method comprising:
coupling a first die electrically coupled to a package substrate; and
electrically coupling an array of die stacks to the first die, wherein the array of die stacks are between the first die and the package substrate, and wherein individual ones of the die stacks comprise:
a plurality of second dies arranged in a vertical stack.

14. The method of claim 13, wherein the first die is a compute die, and wherein the second dies are memory dies.

15. The method of claim 13 or 14, wherein a power delivery path from the package substrate to the first die passes through one or more of the second dies.
